# EUROPÄISCHE PATENTSCHRIFT

(11) **EP 3 724 020 B1**
(45) Veröffentlichungstag und Bekanntmachung des Hinweises auf die Patenterteilung: **14.09.2022**
(21) Anmeldenummer: 18800922.9
(22) Anmeldetag: 09.11.2018
(51) Int. Cl.: H02H 5/04, H02H 6/00, H02H 7/12, B60L 3/00, B60L 3/04, B60L 3/06, B60L 53/20, H05K 7/20, B60W 50/02, B60W 50/023, B60W 20/50

(54) **VERFAHREN UND VORRICHTUNG ZUM BETREIBEN EINES SPANNUNGSWANDLERS**
METHOD AND DEVICE FOR OPERATING A VOLTAGE TRANSFORMER
PROCEDE ET DISPOSITIF POUR LA GESTION D'UN TRANSFORMATEUR DE TENSION

(30) Priorität: 14.12.2017 DE 102017222797
(43) Veröffentlichungstag der Anmeldung: 21.10.2020
(73) Patentinhaber: Robert Bosch GmbH, 70442 Stuttgart (DE)
(72) Erfinder: HELLMANN, Manfred, 71706 Hardthof (DE)
(86) Internationale Anmeldenummer: PCT/EP2018/080772
(87) Internationale Veröffentlichungsnummer: WO 2019/115102

(56) Entgegenhaltungen:
- WO-A2-2012/118625
- JP-A- 2009 255 685
- US-A1- 2015 103 450
- US-A1- 2015 258 947
- US-A1- 2016 105 105
- US-A1- 2017 129 350
- US-A1- 2017 288 593

## Beschreibung

Die Erfindung betrifft ein Verfahren zum Betreiben eines Spannungswandlers, insbesondere Gleichspannungswandlers eines Kraftfahrzeugs, der zumindest zwei parallel geschaltete Wandlerstränge aufweist, die zwischen einer Hochspannungsseite und einer Niederspannungsseite des Spannungswandlers zum Wandeln der Spannung geschaltet sind, mit wenigstens einer ein Kühlmittel führenden und den Wandlersträngen zugeordneten Kühleinrichtung, wobei jedem der Wandlerstränge wenigstens ein Temperatursensor zum Erfassen jeweils einer Wandlertemperatur zugeordnet ist.

Weiterhin betrifft die Erfindung eine Vorrichtung zum Betreiben eines derartigen Spannungswandlers.

### Stand der Technik

Für die Erzeugung der (Niedervolt-)Spannung im Bordnetz eines Kraftfahrzeugs wird bei Kraftfahrzeugen, die auch eine elektrische Antriebsmaschine aufweisen, ein Gleichspannungswandler eingesetzt, welcher die von einer Traktionsbatterie bereitgestellte Hochvoltspannung in eine Niedervoltspannung für das Bordnetz wandelt. Dadurch wird erreicht, dass nicht für das Bordnetz und das Traktionsnetz jeweils ein Energiespeicher (Batterie) zur Verfügung gestellt werden muss, sondern dass der eine Energiespeicher des Traktionsnetzes ausreicht.

Um die Anwendungsmöglichkeiten sowie eine Ausfallsicherheit zu erhöhen, sind Spannungswandler bekannt, die zwei parallel zueinander geschaltete Wandlerstränge aufweisen. Die beiden Wandlerstränge sind in der Regel identisch zueinander ausgebildet und können allein oder gemeinsam die Hochvoltspannung in die der Hochvoltspannung wandeln. In Abhängigkeit von einer Leistungsanforderung werden die Wandlerstränge beispielsweise einzeln oder zusammen betrieben.

Während des Betriebs des Spannungswandlers entsteht Verlustwärme, die zur Erwärmung einerseits der elektrischen Bauteile der Wandlerstränge selbst und andererseits zu den Wandlersträngen benachbarter elektrischer Bauteile führt. Um eine Überhitzung der elektrischen Bauteile und auch der Wandlerstränge zu vermeiden, ist es bekannt, eine Kühleinrichtung den Wandlersträngen zuzuordnen, welche ein Kühlmittel führt, das zum Abtransport der erzeugten Verlustwärme dient. Insbesondere wird beiden Wandlersträngen das gleiche Kühlmittel zugeführt beziehungsweise die Kühleinrichtung bedient beide Wandlerstränge. Dazu liegen die Wandlerstränge beispielsweise in Fließrichtung des Kühlmittels hintereinander.

Als weitere Bauteilschutzmaßnahme ist es bekannt, jedem der Wandlerstränge einen eigenen Temperatursensor zuzuordnen. So kann beispielsweise die Kühlleistung der Kühleinrichtung in Abhängigkeit von der von den Temperatursensoren erfassten Temperaturen optimiert werden.

Aus der Druckschrift US 2017/ 012 93 50 A1 und der Druckschrift JP 2009 255 685 A sind Verfahren zum Betreiben mehrsträngiger Spannungswandler bekannt.

### Offenbarung der Erfindung

Das erfindungsgemäße Verfahren mit den Merkmalen des Anspruchs 1 hat den Vorteil, dass eine Diagnose der Temperatursensoren während des Betriebs auf ihre Funktionsfähigkeit erfolgt. Damit kann im laufenden Betrieb sichergestellt werden, dass die Temperatursensoren ordnungsgemäß funktionieren und in Folge dessen eine Überhitzung der Bauteile vermeidbar ist. Weil die beiden Wandlerstränge mit unterschiedlichen Leistungen betrieben werden können, können auch unterschiedliche Verlustleitungen und damit unterschiedliche Temperaturen in den einzelnen Bauteilen der Wandlerstränge entstehen. Dies hat zur Folge, dass die Temperatursensoren der einzelnen Wandlerstränge unterschiedliche Temperaturen erfassen können. Dadurch wird ein Vergleich der Temperaturen miteinander keine Aussage über die Funktionsfähigkeit der Temperatursensoren erlauben. Erfindungsgemäß ist daher das folgende Vorgehen vorgesehen, um dennoch eine sichere Funktionsdiagnose zu ermöglichen: In einem ersten Schritt a) wird eine Eingangsspannung, eine Ausgangsspannung und ein Betriebsstrom jedes Wandlerstrangs erfasst. Hierzu notwendige Sensoren sind üblicherweise bei Spannungswandlern bereits vorhanden, sodass auf bereits zur Verfügung stehende Daten zurückgegriffen werden kann. Weiterhin wird in einem zweiten Schritt b) eine aktuelle Wandlerstrangtemperatur mittels des jeweiligen Temperatursensors erfasst. Somit stehen zwei Temperaturwerte zur Verfügung. In einem darauffolgenden Schritt c) wird für jeden Wandlerstrang eine Kühlmitteltemperatur in Abhängigkeit von den in den Schritten a) und b) erfassten Werten ermittelt. Beispielsweise durch die Verwendung eines Temperaturmodells lässt sich die Kühlmitteltemperatur in Abhängigkeit der genannten Werte in einfacher Art und Weise berechnen. Anschließend werden in einem Schritt d) die zwei ermittelten Kühlmitteltemperaturen miteinander verglichen und in einem Schritt e) die Funktionsfähigkeit der Temperatursensoren in Abhängigkeit von dem Ergebnis des Vergleichs bestimmt. In Kenntnis des Aufbaus des Spannungswandlers ist es möglich, die jeweilige Kühlmitteltemperatur verhältnismäßig genau zu ermitteln. Weil davon ausgegangen wird, dass das Kühlmittel beiden Wandlersträngen zugeführt wird, müsste die Temperatur des Kühlmittels an beiden Wandlersträngen nahezu gleich sein. Insbesondere, wenn das Kühlmittel parallel den beiden Wandlersträngen zugeführt wird, ist dies der Fall. Wird das Kühlmittel den Wandlersträngen nacheinander zugeführt, so kann sich eine Temperaturdifferenz von dem einen Wandlerstrang zum nächsten Wandlerstrang bereits einstellen. Diese Temperaturdifferenz ist jedoch in Abhängigkeit der oben genannten Werte herausrechenbar beziehungsweise bei einem Vergleich der ermittelten Kühlmitteltemperaturen, beispielsweise durch einen Toleranzwert berücksichtigbar. Durch den Vergleich der ermittelten Kühlmitteltemperaturen, die gleich oder nahezu gleich zueinander sein müssten, insbesondere bei parallel zugeführtem Kühlmittel, ist somit eine einfache Diagnose der Temperatursensoren möglich.

Insbesondere werden die Kühlmitteltemperaturen, wie oben bereits erwähnt, mittels jeweils eines Temperaturmodells berechnet. Hierdurch ist eine zeitnahe und einfache Berechnung der Kühlmitteltemperaturen gewährleistet.

Weiterhin ist bevorzugt vorgesehen, dass dann, wenn die ermittelten Kühltemperaturen gleich oder nahezu gleich sind, auf die Funktionsfähigkeit der Temperatursensoren erkannt wird.

Insbesondere wird dann, wenn die ermittelten Kühlmitteltemperaturen über einen vorgebbaren Grenzwert hinaus voneinander abweichen, wird auf einen Funktionsfehler eines der Temperatursensoren erkannt. Dabei wird der Grenzwert insbesondere in Abhängigkeit davon gewählt, ob die Wandlerstränge nacheinander oder parallel zueinander mit dem Kühlmittel beaufschlagt werden. Werden die Wandlungsspanner nacheinander mit dem Kühlmittel beaufschlagt, so wird der Grenzwert bevorzugt größer gewählt als bei einer parallelen Beaufschlagung, weil durch die unterschiedlichen Verlustleistungen der Wandlerstränge bereits eine Erwärmung des Kühlmittels durch den in Strömungsrichtung vorneliegenden Wandlerstrang erfolgt sein kann.

Weiterhin ist bevorzugt vorgesehen, dass bei Erkennen eines Funktionsfehlers der Spannungswandler oder ein Spannungswandler aufweisendes Steuergerät in einen sicheren Notbetrieb geschaltet werden. Dadurch wird die Sicherheit, insbesondere die Fahrsicherheit und die Personensicherheit des Kraftfahrzeugs gewährleistet.

Weiterhin ist bevorzugt vorgesehen, dass eine weitere Kühlmitteltemperatur erfasst und mit den ermittelten Kühlmitteltemperaturen verglichen wird, um zu bestimmen, welcher von beiden Temperatursensoren eine Fehlfunktion aufweist. Die weitere Kühlmitteltemperatur kann beispielsweise durch ein separates Steuergerät und/oder ein die Kühleinrichtung selbst ermittelt werden. Sie dient somit als Referenzwert für die mittels der Temperatursensoren ermittelten Kühlmitteltemperaturen im Schritt c). Dadurch ist insgesamt nicht nur feststellbar, dass eine Fehlfunktion an einem der Temperatursensoren vorliegt, es kann vielmehr erkannt werden, welcher der beiden Temperatursensoren die Fehlfunktion aufweist. In Folge dessen wird beispielsweise für den Not-Betriebsmodus der von dem Funktionsfehler betroffene Wandlerstrang deaktiviert und ein Weiterbetrieb des Spannungswandlers durch den verbleibenden Wandlerstrang gewährleistet.

Weiterhin ist bevorzugt vorgesehen, dass die weitere Kühltemperatur gemessen wird. Dadurch ist eine besonders genaue Erfassung der Kühlmitteltemperatur gewährleistet, und ein sicherer Vergleich mit den in Schritt c) ermittelten Kühlmitteltemperaturen durchführbar.

Die erfindungsgemäße Vorrichtung mit den Merkmalen des Anspruchs 8 zeichnet sich dadurch aus, dass sie als Steuergerät ausgebildet ist, das speziell dazu hergerichtet ist, das erfindungsgemäße Verfahren durchzuführen. Es ergeben sich hierdurch die bereits genannten Vorteile.

Weitere Vorteile und bevorzugte Merkmale und Merkmalskombinationen ergeben sich insbesondere aus dem zuvor Beschriebenen sowie aus den Ansprüchen.

Im Folgenden soll die Erfindung anhand der Zeichnung näher erläutert werden. Dazu zeigen
- Figur 1: einen Spannungswandler in einer vereinfachten Darstellung und
- Figur 2: ein vorteilhaftes Verfahren zum Betreiben des Spannungswandlers.

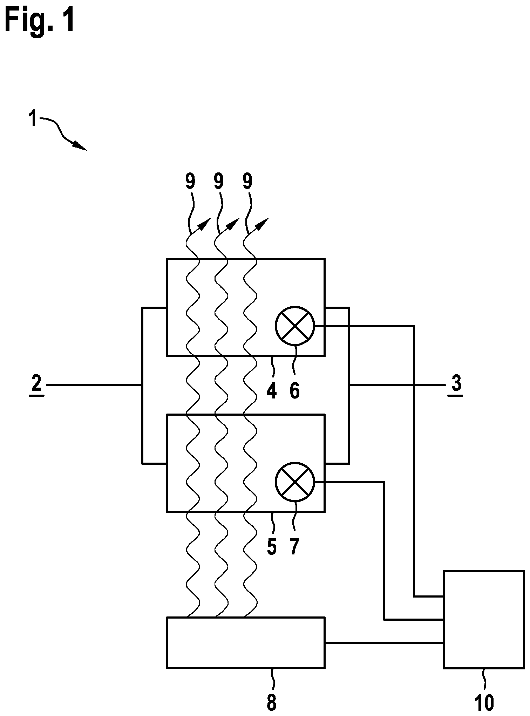

Figur 1 zeigt in einer vereinfachten Darstellung einen vorteilhaften Spannungswandler 1, der zwischen einer Hochspannungsseite 2 und einer Niederspannungsseite 3 geschaltet ist, um die Niederspannungsseite mit Energie aus der Hochspannungsseite 2 zu versorgen. Vorliegend handelt es sich um einen Spannungswandler 1 eines Kraftfahrzeugs, das als Elektrofahrzeug oder als Hybridfahrzeug ausgebildet ist und zumindest eine elektrische Antriebsmaschine aufweist, die durch eine Traktionsbatterie aus dem Hochspannungsnetz 2 gespeist wird. Durch den Spannungswandler 1 wird ermöglicht, dass das Niederspannungsnetz, das beispielsweise das Bordnetz des Kraftfahrzeugs mit einer Spannung von 12 bis 14 V bildet, keinen eigenen Energiespeicher benötigt.

Der vorteilhafte Spannungswandler 1 weist zwei parallel zueinander geschaltete Wandlerstränge 4 und 5 auf. Die Wandlerstränge 4, 5 sind im Wesentlichen identisch zueinander ausgebildet und weisen bevorzugt jeweils einen Gleichspannungswandler auf. Außerdem weist jeder der Wandlerstränge 4, 5 einen Temperatursensor 6, 7 auf, mittels dessen die Temperatur des jeweiligen Wandlerstrangs 4, 5 überwacht wird.

Außerdem ist dem Spannungswandler 1 eine Kühleinrichtung 8 zugeordnet, welche ein Kühlmittel fördert, das beide Wandlerstränge 4, 5 beaufschlagt, um dort im Betrieb entstandene Verlustwärme abzuführen. Gemäß dem vorliegenden Ausführungsbeispiel werden die Wandlerstränge 4, 5 nacheinander mit dem Kühlmittel 9, das in Figur 1 durch Pfeile gezeigt ist, beaufschlagt. Bei dem Kühlmittel 9 kann es sich beispielsweise um Kühlmittelflüssigkeit oder um einen Kühlmittelgasstrom, insbesondere Luftstrom, handeln.

Vorteilhafterweise ist außerdem ein Steuergerät 10 vorhanden, das mit den Temperatursensoren 6, 7, der Kühleinrichtung 8 und den Wandlersträngen 4, 5 verbunden ist, um den Betrieb des Spannungswandlers 1 durchzuführen. Insbesondere steuert das Steuergerät 10 beispielsweise die Kühleinrichtung 8 in Abhängigkeit von den durch die Temperatursensoren 6, 7 ermittelten Temperaturwerten an, um einen optimalen Betrieb der Wandlerstränge 4, 5 zu gewährleisten.

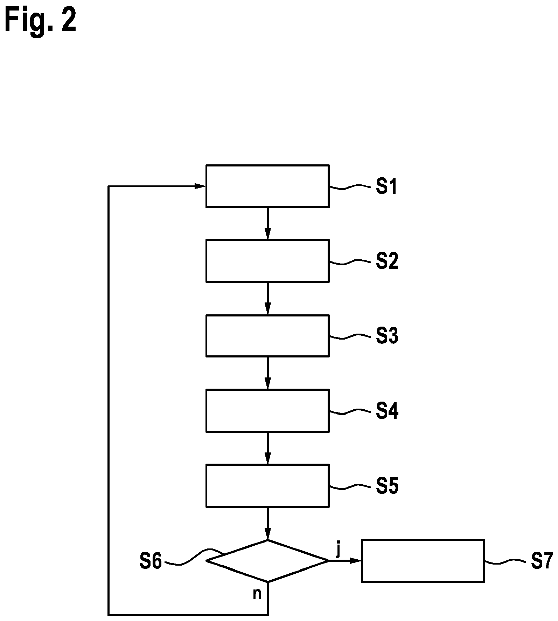

Um die Temperatursensoren 6, 7 auf Fehler oder auf Fehlfunktionen zu überwachen, führt das Steuergerät 10 außerdem eine vorteilhafte Diagnose durch, die mit Bezug auf Figur 2 im Folgenden näher erläutert werden soll.

Figur 2 zeigt dazu ein Flussdiagramm zur Erläuterung des vorteilhaften Diagnoseverfahrens, das in dem Schritt S1 beginnt, beispielsweise mit der Inbetriebnahme des Spannungswandlers 1. In einem darauffolgenden Schritt S2 werden die Eingangsspannung, die Ausgangsspannung, sowie der Betriebsstrom und die aktuelle Temperatur des Wandlerstrangs 4 ermittelt. Zum Ermitteln der Temperatur wird der Temperatursensor 6 genutzt und zum Ermitteln der Spannungs- und Strom-Werte werden bevorzugt in dem Wandlerstang 4 ohnehin vorhandene Sensoren genutzt. In einem darauffolgenden Schritt S3 wird in Abhängigkeit der in Schritt S2 ermittelten Werte eine Kühlmitteltemperatur T_1 des Kühlmittels 9 im Bereich des Wandlerstrangs 4 berechnet. Hierzu wird vorteilhafterweise ein Temperaturmodell verwendet, welches eine einfache und zeitnahe Berechnung der Kühlmitteltemperatur T_1 erlaubt.

In einem darauffolgenden Schritt S4 werden Eingangsspannung, Ausgangsspannung und Betriebsstrom sowie die durch den Temperatursensor 7 erfasste Temperatur des Wandlerstrangs 5 erfasst beziehungsweise eingelesen. Im darauffolgenden Schritt S5 wird aus den in Schritt S4 ermittelten Werten, insbesondere mittels eines weiteren Temperaturmodells, die Kühlmitteltemperatur T_2 des Kühlmittels im Bereich des Wandlerstrangs 5 ermittelt. Optional werden die Schritt S2, S3 und S4, S5 parallel zueinander durchgeführt.

Anschließend werden in einer Abfrage S6 die ermittelten Kühlmitteltemperaturen T_1 und T_2 miteinander verglichen. Dabei wird insbesondere eine Abweichung der Kühlmitteltemperaturen T_1, T_2 voneinander geprüft, wobei die Abweichung mit einem vorgebbaren Toleranz- oder Grenzwert T_Δ verglichen wird. Der Grenzwert T_Δ wird insbesondere in Abhängigkeit davon gewählt, ob die Kühleinrichtung 8 die Wandlerstränge 4, 5 nacheinander oder parallel mit dem Kühlmittel 9 beaufschlagt. Werden die Wandlerstränge 4, 5 parallel beaufschlagt, so wird der Grenzwert niedriger gewählt.

Übersteigt der Vergleich der Kühlmitteltemperaturen den Grenzwert, so wird darauf erkannt, dass einer der Temperatursensoren 6, 7 eine Fehlfunktion aufweist. Es wird davon ausgegangen, dass die durch die Temperaturwerte ermittelten beziehungsweise berechneten Kühlmitteltemperaturen gleich oder nahezu gleich sein müssten. Überschreiten die Differenz zwischen den Kühlmitteltemperaturen T_1, T_2 jedoch den Grenzwert (j), ist dies ein Zeichen dafür, dass einer der Temperatursensoren 6, 7 nicht korrekt arbeitet. In Folge dessen wird in einem Schritt S7 ein Notbetrieb eingeleitet, bei welchem beispielsweise der Spannungswandler 1 deaktiviert und/oder eine Warnmeldung an einen Fahrer des Kraftfahrzeugs ausgegeben wird. Insbesondere wird der erkannte Fehler auch gespeichert.

Liegt die ermittelte Temperaturdifferenz unterhalb des Grenzwertes T_Δ (n), wird erkannt, dass die Temperatursensoren 6, 7 ordnungsgemäß funktionieren und das Verfahren wird im Schritt S1 oder S2 weitergeführt.

Optional wird eine Kühlmitteltemperatur des Kühlmittels 9 zusätzlich direkt erfasst, beispielsweise durch die Kühleinrichtung 8, um einen Referenzwert zur Verfügung zu stellen, mit welchem die beiden Kühlmitteltemperaturen T_1 und T_2 verglichen werden können. Dadurch ist es nicht nur unmöglich, eine Fehlfunktion des Spannungswandlers 1 zu erkennen, sondern auch zu ermitteln, welcher der beiden Temperatursensoren 6, 7 die Fehlfunktion aufweist. Dies hat den Vorteil, dass beispielsweise für den Not-Betriebsmodus nur der den defekten Temperatursensor 6 oder 7 aufweisende Wandlerstrang 4, 5 deaktiviert wird, sodass ein Weiterbetrieb des Spannungswandlers grundsätzlich möglich ist.

## Patentansprüche

1. Verfahren zum Betreiben eines Spannungswandlers (1), insbesondere Gleichspannungswandler, eines Kraftfahrzeugs, der zumindest zwei parallel geschaltete Wandlerstränge (4,5) aufweist, die zwischen einer Hochspannungsseite (2) und einer Niederspannungsseite (3) des Spannungswandlers (1) zum Wandeln der Spannung geschaltet sind, mit wenigstens einer ein Kühlmittel (9) führenden und den Wandlersträngen (4,5) zugeordneten Kühleinrichtung (8), wobei jedem der Wandlerstränge (4,5) wenigstens ein Temperatursensor (6,7) zugeordnet ist, mit folgenden Schritten:
a) Erfassen einer Eingangsspannung, einer Ausgangsspannung und eines Betriebsstroms jedes Wandlerstrangs (4,5),
b) Erfassen einer aktuellen Wandlerstrangtemperatur mittels des jeweiligen Temperatursensors (6,7),
c) Ermitteln je einer Kühlmitteltemperatur in Abhängigkeit von den in den Schritten a) und b) erfassten Werten für jeden Wandlerstrang,
d) Vergleichen der zwei ermittelten Kühlmitteltemperaturen (T_1,T_2) miteinander und
e) Bestimmen der Funktionsfähigkeit der Temperatursensoren (6,7) in Abhängigkeit von dem Ergebnis des Vergleichs.

2. Verfahren nach Anspruch 1, **dadurch gekennzeichnet, dass** die Kühlmitteltemperaturen (T_1,T_2) mittels jeweils eines Temperaturmodells berechnet werden.

3. Verfahren nach einem der vorhergehenden Ansprüche, **dadurch gekennzeichnet, dass** dann, wenn die ermittelten Kühlmitteltemperaturen (T_1,T_2) gleich oder nahezu gleich sind, auf die Funktionsfähigkeit der Temperatursensoren erkannt wird.

4. Verfahren nach einem der vorhergehenden Ansprüche, **dadurch gekennzeichnet, dass** dann, wenn die ermittelten Kühlmitteltemperaturen über einen vorgebbaren Grenzwert hinaus voneinander abweichen, auf einen Funktionsfehler erkannt wird.

5. Verfahren nach einem der vorhergehenden Ansprüche, **dadurch gekennzeichnet, dass** bei Erkennen eines Funktionsfehlers der Spannungswandler oder ein den Spannungswandler aufweisendes Steuergerät in einen sicheren Not-Betriebsmodus geschaltet werden.

6. Verfahren nach einem der vorhergehenden Ansprüche, **dadurch gekennzeichnet, dass** eine weitere Kühlmitteltemperatur erfasst und mit den ermittelten Kühlmitteltemperaturen (T_1,T_2) verglichen wird, um zu bestimmen, welcher von beiden Temperatursensoren (6,7) eine Fehlfunktion aufweist.

7. Verfahren nach Anspruch 6, **dadurch gekennzeichnet, dass** die weitere Kühlmitteltemperatur gemessen wird.

8. Vorrichtung zum Betreiben eines Spannungswandlers (1), der zumindest zwei parallel geschaltete Wandlerstränge (4,5) aufweist, die zwischen einer Hochspannungsseite und einer Niederspannungsseite des Spannungswandlers (1) zum Wandeln der Spannung geschaltet sind, sowie wenigstens eine ein Kühlmittel führende und den Wandlersträngen (4,5) zugeordnete Kühleinrichtung (8), wobei jedem der Wandlerstränge (4,5) wenigstens ein Temperatursensor (6,7) zugeordnet ist, **gekennzeichnet durch** die Ausbildung als Steuergerät (10), das speziell dazu hergerichtet ist, das Verfahren nach einem der Ansprüche 1 bis 7 durchzuführen.

## Claims

1. Method for operating a voltage converter (1), in particular a DC/DC converter, of a motor vehicle, having at least two converter strands (4, 5) which are connected in parallel and are connected between a high-voltage side (2) and a low-voltage side (3) of the voltage converter (1) for converting the voltage, having at least one cooling device (8) which carries a coolant (9) and is assigned to the converter strands (4, 5), wherein at least one temperature sensor (6, 7) is assigned to each of the converter strands (4, 5), having the following steps of:
a) capturing an input voltage, an output voltage and an operating current of each converter strand (4, 5),
b) capturing an instantaneous converter strand temperature by means of the respective temperature sensor (6, 7),
c) determining a coolant temperature for each converter strand on the basis of the values captured in steps a) and b),
d) comparing the two determined coolant temperatures (T_1, T_2) with one another, and
e) determining the functionality of the temperature sensors (6, 7) on the basis of the result of the comparison.

2. Method according to Claim 1, **characterized in that** the coolant temperatures (T_1, T_2) are calculated by means of a temperature model in each case.

3. Method according to either of the preceding claims, **characterized in that** the functionality of the temperature sensors is identified when the determined coolant temperatures (T_1, T_2) are the same or virtually the same.

4. Method according to one of the preceding claims, **characterized in that** a functional fault is identified when the determined coolant temperatures differ from one another beyond a predefinable limit value.

5. Method according to one of the preceding claims, **characterized in that** the voltage converter or a control unit having the voltage converter is switched to a safe emergency operating mode if a functional fault is identified.

6. Method according to one of the preceding claims, **characterized in that** a further coolant temperature is captured and is compared with the determined coolant temperatures (T_1, T_2) in order to determine which of the two temperature sensors (6, 7) has a malfunction.

7. Method according to Claim 6, **characterized in that** the further coolant temperature is measured.

8. Device for operating a voltage converter (1) having at least two converter strands (4, 5) which are connected in parallel and are connected between a high-voltage side and a low-voltage side of the voltage converter (1) for converting the voltage and having at least one cooling device (8) which carries a coolant and is assigned to the converter strands (4, 5), wherein at least one temperature sensor (6, 7) is assigned to each of the converter strands (4, 5), **characterized by** the design as a control unit (10) which is specifically configured to carry out the method according to one of Claims 1 to 7.

## Revendications

1. Procédé de fonctionnement d'un convertisseur de tension (1), notamment un convertisseur de tension continue, d'un véhicule automobile, qui comporte au moins deux phases de convertisseur (4, 5) montées en parallèle qui sont montées entre un côté à haute tension (2) et un côté à basse tension (3) du convertisseur de tension (1) pour convertir la tension, ledit convertisseur comprenant au moins un dispositif de refroidissement (8) guidant un agent de refroidissement (9) et associé aux phases du convertisseur (4, 5), au moins un capteur de température (6,7) étant associé à chacune des branches du convertisseur (4, 5), ledit procédé comprenant les étapes suivantes :
a) détecter une tension d'entrée, une tension de sortie et un courant de fonctionnement de chaque phase de convertisseur (4, 5),
b) détecter une température de phase de convertisseur actuelle à l'aide du capteur de température respectif (6, 7),
c) déterminer une température d'agent de refroidissement respective en fonction des valeurs détectées aux étapes a) et b) pour chaque phase de convertisseur,
d) comparer les deux températures d'agent de refroidissement déterminées (T_1, T_2) entre elles et
e) déterminer la capacité de fonctionnement des capteurs de température (6, 7) en fonction du résultat de la comparaison.

2. Procédé selon la revendication 1, **caractérisé en ce que** les températures d'agent de refroidissement (T_1, T_2) sont calculées au moyen d'un modèle de température respectif.

3. Procédé selon l'une des revendications précédentes, **caractérisé en ce que** la capacité de fonctionnement des capteurs de température est détectée lorsque les températures d'agent de refroidissement déterminées (T_1, T_2) sont identiques ou presque identiques.

4. Procédé selon l'une des revendications précédentes, **caractérisé en ce qu'**un dysfonctionnement est détecté lorsque les températures d'agent de refroidissement déterminées diffèrent l'une de l'autre de plus d'une valeur limite spécifiée.

5. Procédé selon l'une des revendications précédentes, **caractérisé en ce que**, lorsqu'un dysfonctionnement est détecté, le convertisseur de tension ou une unité de commande comportant le convertisseur de tension est commuté(e) dans un mode de fonctionnement d'urgence sécurisé.

6. Procédé selon l'une des revendications précédentes, **caractérisé en ce qu'**une autre température d'agent de refroidissement est détectée et comparée aux températures d'agent de refroidissement déterminées (T_1, T_2) afin de déterminer lequel des deux capteurs de température (6, 7) présente un dysfonctionnement.

7. Procédé selon la revendication 6, **caractérisé en ce que** l'autre température d'agent de refroidissement est mesurée.

8. Dispositif destiné à faire fonctionner un convertisseur de tension (1), qui comporte au moins deux phases de convertisseur (4, 5) montées en parallèle qui sont montées entre un côté à haute tension et un côté à basse tension du convertisseur de tension (1) afin de convertir la tension, et au moins un dispositif de refroidissement (8) guidant l'agent de refroidissement et associé aux phases de convertisseur (4, 5), au moins un capteur de température (6, 7) étant associé à chacune des phases de convertisseur (4, 5), **caractérisé en ce que** ledit dispositif est conçu comme une unité de commande (10) qui est spécialement prévue pour mettre en œuvre le procédé selon l'une des revendications 1 à 7.
